# EUROPEAN PATENT APPLICATION

(11) **EP 2 271 192 A2**
(43) Date of publication of application: **05.01.2011**
(21) Application number: 10168198.9
(22) Date of filing: 02.07.2010
(51) Int. Cl.: H05K 1/18, H01M 2/34, H01M 10/42

(54) **Protection circuit board, secondary battery, and battery pack**

(30) Priority: 02.07.2009 KR 20090060165
(71) Applicant: Samsung SDI Co., Ltd., Yongin-si, Gyeonggi-do (KR)
(72) Inventor: Jang, Youngcheol, YONGIN-SI (KR)
(74) Representative: Santarelli

(57) **Abstract**

A protection circuit board, a secondary battery, and a battery pack including a secondary battery. In embodiments of a protection circuit board, as well as a secondary battery and a battery pack including a protection circuit board, a secondary protection device (120) is disposed in a board body (110) of the protection circuit board (100) for facilitating fabrication and improving performance of the secondary protection device without using an additional structure for insulating the secondary protection device and the bare cell.

## Description

### BACKGROUND

### 1. Field

Embodiments of the present invention relate to a secondary battery, and more particularly, to a protection circuit board including a secondary protection device, a secondary battery including the protection circuit board, and a battery pack including the secondary battery.

### 2. Description of the Related Art

Secondary batteries are rechargeable batteries that can be repeatedly used and recharged. Secondary batteries are used in various portable multimedia devices such as cellular phones, laptop computers, and camcorders.

A secondary battery typically includes a can, an electrode assembly disposed in the can, and a bare cell. The bare cell may include a cap assembly connected to an opening of the can and electrically connected to an external terminal. The secondary battery may include a protection circuit board electrically connected to the bare cell. A secondary battery may be included in a battery pack. Additionally, a protection device may be provided at the protection circuit board for preventing over-charging and over-discharging of the bare cell.

A protection device such as a positive temperature coefficient (PTC) device or a thermal fuse is often installed at a protection circuit board. The protection device may be referred to as "a secondary protection device" to distinguish it from a primary protection device, such as a safety vent.

A typical secondary protection device breaks a current when the temperature of the secondary battery increases excessively or the voltage of the secondary battery increases excessively due to over-charging or over-discharging. Breakage or deterioration of the secondary battery may thereby be prevented by a secondary protection device. A primary protection device is typically installed in a bare cell such that the primary protection device may be sensitive to the temperature of the bare cell.

The secondary protection device is typically installed in a space between the bare cell and the protection circuit board, and a structure is provided at the secondary protection device for electrically connecting the protection circuit board and the bare cell. As such, the manufacturing process of the protection circuit board, and/or the assembling process of the protection circuit board and the bare cell is typically complicated.

In addition, the secondary protection device is electrically connected to a first electrode of the bare cell and is insulated from a second electrode of the bare cell. Therefore, in a conventional secondary battery, an additional structure is formed to insulate the secondary protection device from the outer surface of the bare cell, thereby complicating manufacturing processes and increasing cost. If the secondary protection device is not insulated, the secondary protection device cannot perform its function, and moreover, the secondary battery is susceptible to malfunction.

Moreover, because a secondary protection device is typically installed in a space between the bare cell and the protection circuit board, the size of a battery pack may be increased, or the space may not be used for other purposes.

### SUMMARY

Embodiments of the present invention are directed to a protection circuit board, a secondary battery, and a battery pack, which overcome or substantially overcome one or more of the problems resulting from the limitations and disadvantages of the related art.

Aspects of embodiments of the present invention provide a protection circuit board having a simple structure by disposing a secondary protection device therein.

Aspects of other embodiments of the present invention provide a secondary battery in which a secondary protection device is disposed inside a protection circuit board for insulating the secondary protection device from a bare cell.

Aspects of still other embodiments of the present invention provide a battery pack in which a secondary protection device is disposed inside a protection circuit board, thereby saving space between the protection circuit board and a bare cell.

According to one exemplary embodiment of the present invention, a protection circuit board includes a board body, and a secondary protection device inside the board body.

The board body may have a generally rectangular parallelepiped shape and a hole at a central portion, and the protection circuit board may further include an external terminal at one surface of the board body, and a charge/discharge device on another surface of the board body.

The board body may include at least two circuit layers, and a first end part of the secondary protection device may be connected to an uppermost layer of the circuit layers, and a second end part of the secondary protection device may be connected to a lowermost layer of the circuit layers.

The protection circuit board may further include insulating layers on top and bottom surfaces of the board body.

The insulating layers may include photoimageable solder resist (PSR) layers.

The secondary protection device may not be exposed outside the board body.

The secondary protection device may include a positive temperature coefficient (PTC) device.

The PTC device may include a PTC main body having a generally rectangular parallelepiped shape; a first conductive part on at least one surface of the PTC main body; and a second conductive part spaced apart from the first conductive part and on at least one surface of the PTC main body that does not have the first conductive part thereon.

According to another exemplary embodiment, a secondary battery includes a bare cell, and a protection circuit board electrically connected to the bare cell, wherein the protection circuit board includes a board body and a secondary protection device inside the board body.

The bare cell may include a can; an electrode assembly in the can; and a cap assembly closing an opening of the can.

The protection circuit board may further include an electrode terminal at a center part of the board body and connected to a first electrode of the bare cell; and electrodes at end parts of the board body and connected to a second electrode of the bare cell.

The secondary protection device may not be exposed outside the board body.

The protection circuit board may further include insulating layers on top and bottom surfaces of the board body.

The insulating layers may include PSR layers.

The secondary protection device may include a PTC device.

According to another exemplary embodiment, a battery pack includes: a bare cell; a protection circuit board electrically connected to the bare cell; and a top case coupling the protection circuit board to a side of the bare cell, wherein the protection circuit board includes a board body and a secondary protection device inside the board body.

The bare cell may include a can; an electrode assembly in the can; and a cap assembly closing an opening of the can.

The protection circuit board may further include an electrode terminal at a center part of the board body and connected to a first electrode of the bare cell; and electrodes at end parts of the board body and connected to a second electrode of the bare cell.

The secondary protection device may not be exposed outside the board body.

The protection circuit board may further include insulating layers on top and bottom surfaces of the board body.

The insulating layers may include PSR layers.

The secondary protection device may include a PTC device.

The battery pack may further include a bottom case coupled to another side of the bare cell. The battery pack may further include a label sheet enclosing lateral surfaces of the bare cell, the top case, and the bottom case.

### BRIEF DESCRIPTION OF THE DRAWINGS

The above and other features and advantages will become more apparent to those of ordinary skill in the art by describing in detail exemplary embodiments with reference to the attached drawings, in which:

FIG. 1 is a side view of a protection circuit board according to one embodiment of the present invention;

FIG. 2 is a perspective view of the protection circuit board of FIG. 1;

FIG. 3 is a cross-sectional view of a positive temperature coefficient (PTC) device of the protection circuit board of FIG. 1;

FIG. 4 is an exploded partial perspective view of a secondary battery according to one embodiment of the present invention;

FIG. 5 is a partial front view of the secondary battery of FIG. 4, showing an assembled state of the secondary battery; and

FIG. 6 is an exploded perspective view of a battery pack according to one embodiment of the present invention.

### DETAILED DESCRIPTION

Certain exemplary embodiments are described more fully herein with reference to the accompanying drawings; however, embodiments of the present invention may be embodied in different forms and should not be construed as limited to the embodiments set forth herein. Rather, these exemplary embodiments are provided by way of example for understanding of the invention and to convey the scope of the invention to those skilled in the art.

In the drawings, the dimensions of layers and regions may be exaggerated for clarity of illustration. It will also be understood that when a layer or element is referred to as being "on" another layer or substrate, it may be directly on the other layer or substrate, or intervening layers may also be present. Further, it will be understood that when a layer is referred to as being "under" another layer, it may be directly under, or one or more intervening layers may also be present. In addition, it will also be understood that when a layer is referred to as being "between" two layers, it may be the only layer between the two layers, or one or more intervening layers may also be present. Further, like reference numerals refer to like elements throughout the following description.

Hereinafter, certain exemplary embodiments will be described in detail with reference to the accompanying drawings.

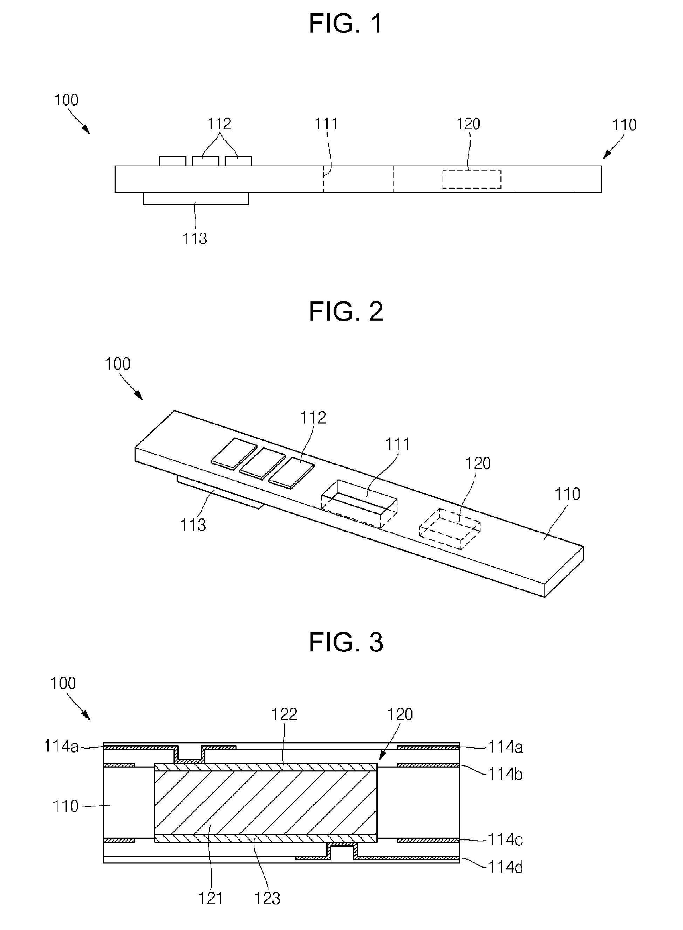

FIG. 1 is a side view of a protection circuit board according to one exemplary embodiment of the present invention. FIG. 2 is a perspective view of the protection circuit board of FIG. 1. FIG. 3 is a cross-sectional view of a positive temperature coefficient (PTC) device according to one exemplary embodiment of the present invention.

With reference to FIGS. 1 to 3, according to one exemplary embodiment, a protection circuit board 100 includes a board body 110 and a secondary protection device 120 disposed in the board body 110.

The board body 110, in one embodiment, has a shape generally or approximately of a rectangular parallelepiped. A hole 111 is formed in a center part of the board body 110. In one embodiment, external terminals 112 are mounted on a surface (e.g., a top surface) of the board body 110 to transmit a current to an external part, and a charge/discharge device 113 is mounted on another surface (e.g., a bottom surface) of the board body 110.

The secondary protection device 120, in one exemplary embodiment, is disposed in the board body 110 such that the secondary protection device 120 is embedded in the board body 110 and not exposed to the outside of the board body 110.

The secondary protection device 120 may be installed during a manufacturing process of a printed circuit board that constitutes the board body 110. At least two or four circuit layers 114a, 114b, 144c, 114d may be formed in the board body 110. In one exemplary embodiment, an upper end part of the secondary protection device 120 is connected to an uppermost layer 114a of the circuit layers, and a lower end part of the secondary protection device 120 is connected to a lowermost layer 114d of the circuit layers. In this way, the secondary protection device 120 is electrically connected to the circuit layers 114a, 114d of the board body 110 to form a circuit structure.

The top and bottom surfaces of the board body 110, in an exemplary embodiment, are coated with photoimageable solder resist (PSR) ink. When the printed circuit board is fabricated, the PSR treatment process is performed to form an insulating layer on the circuitry of the printed circuit board. As a result of the PSR treatment, when a component is mounted on the printed circuit board in a later soldering process, formation of a solder bridge between circuits may be prevented or substantially prevented. That is, by performing such a PSR treatment process, the secondary protection device 120 can be insulated.

A PTC device or a protection device equivalent or substantially equivalent to a PTC device may be used as the secondary protection device 120 (hereinafter, also referred to as a PTC device 120). However, the secondary protection device 120 is not limited thereto and may alternatively include any other suitable protection device.

With further reference to FIG. 3, the PTC device 120, in one embodiment, includes a PTC main body 121 having a shape generally or approximately of a rectangular parallelepiped, a first conductive part 122 enclosing at least one surface of the PTC main body 121, and a second conductive part 123 spaced apart from the first conductive part 122 and enclosing at least one remaining surface of the PTC main body 121. The first conductive part 122 is connected to one circuit layer 114a of the circuit layers of the board body 110, and the second conductive part 123 is connected to another circuit layer 114d of the circuit layers of the board body 110.

The PTC main body 121, in one embodiment, is fabricated by dispersing conductive particles in a crystalline polymer. Carbon particles may be used as the conductive particles, and a synthetic resin such as a polyolefine-based polymer may be used as the crystalline polymer. At temperatures equal to or less than a reference, or preselected, temperature, the conductive particles of the PTC main body 121 clump together such that the first conductive part 122 and the second conductive part 123 are electrically connected through the PTC main body 121. However, at temperatures greater than the reference temperature, the crystalline polymer of the PTC main body 121 expands, and the conductive particles of the PTC main body 121 are separated to increase the electric resistance of the PTC main body 121. Therefore, no current, or only a small amount of current, may flow between the first conductive part 122 and the second conductive part 123. That is, in this case, no current, or only a small amount of current, may flow in the PTC main body 121 that connects the first conductive part 122 and the second conductive part 123.

Therefore, the PTC device 120 can be used as a safety device for preventing breakage of a battery. For example, due to heat generated by overcurrent, overvoltage, or over power consumption, the temperature of the battery can increase higher than a preset, or reference, temperature. Thereafter, if the temperature of the PTC main body 121 decreases to a temperature equal to or lower than the preset temperature, the crystalline polymer of the PTC main body 121 shrinks to clump the conductive particles, and thus the PTC main body 121 becomes conductive.

In the described exemplary embodiment, since the PTC device 120 (secondary protection device) is disposed inside the board body 110 of the protection circuit board 100, an additional insulation structure is unnecessary. In addition, the size of the protection circuit board 100 is not increased by the PTC device 120.

A secondary battery according to another exemplary embodiment of the present invention is described below.

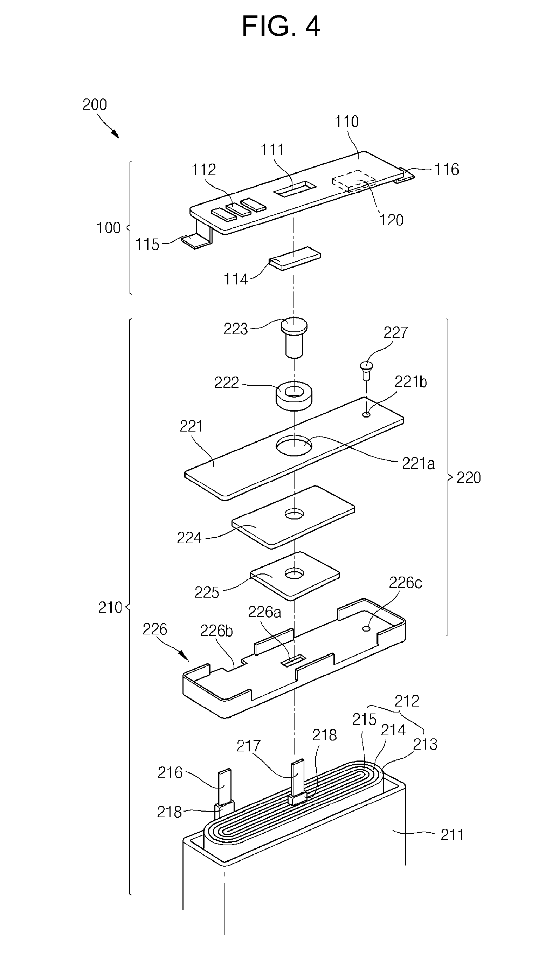

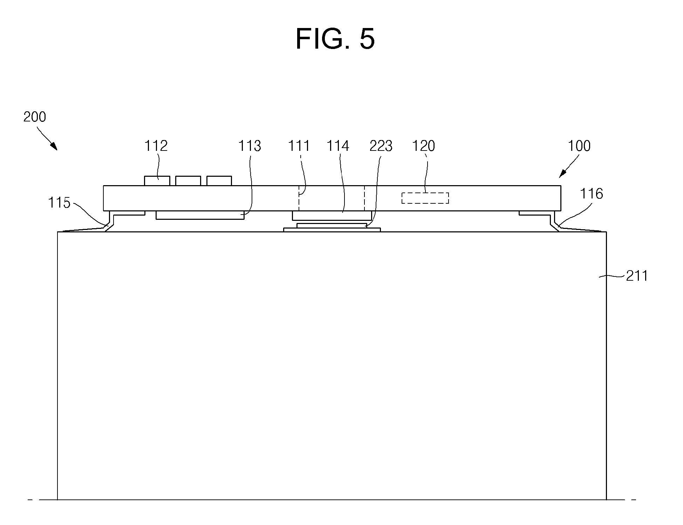

FIG. 4 is an exploded partial perspective view of a secondary battery according to one exemplary embodiment of the present invention. FIG. 5 is a partial front view of the secondary battery of FIG. 4, showing an assembled state of the secondary battery.

With reference to FIGS. 4 and 5, in one exemplary embodiment, a secondary battery 200 includes a bare cell 210 and a protection circuit board 100 electrically connected to the bare cell 210. The protection circuit board 100 includes a board body 110 in which a PTC device 120 is disposed. The protection circuit board 100 and the PTC device 120, in one embodiment, have the same or substantially similar structures as the protection circuit board 100 and the PTC device 120 described above. Therefore, like reference numerals are used for the protection circuit board 100 and the PTC device 120, and detailed descriptions thereof will not be repeated herein.

The bare cell 210 includes a can 211, an electrode assembly 212 accommodated in the can 211, and a cap assembly 220 configured to close an opening of the can 211.

The can 211, in one embodiment, is a container generally or approximately shaped as a rectangular parallelepiped and having an opening formed in an end part of the can 211. The can 211 may be formed by a method such as deep drawing. The can 211, in one embodiment, functions as a terminal. The can 211 may be formed of a light conductive metal such as aluminum, an aluminum alloy, or any other suitable material. The can 211 is configured to accommodate, or contain, the electrode assembly 212 and electrolyte, and the opening of the can 211 is closed by the cap assembly 220 after the electrode assembly 212 is inserted into the can 211 through the opening.

The electrode assembly 212 includes a positive electrode plate 213, a separator 214, a negative electrode plate 215, a positive electrode tab 216 extending from the positive electrode plate 213, a negative electrode tab 217 extending from the negative electrode plate 215, and insulating tapes 218 attached to the positive electrode tab 216 and the negative electrode tab 217.

The separator 214 is disposed between the positive electrode plate 213 and the negative electrode plate 215, and the positive electrode plate 213, the separator 214, and the negative electrode plate 215 are wound in a so-called "jelly roll" shape. The positive electrode plate 213 may be formed by coating an aluminum-foil collector with a positive electrode active material such as a lithium cobalt dioxide (LiCoO₂) and the negative electrode plate 215 may be formed by coating a copper-foil collector with a negative electrode active material such as carbon. The separator 214 may be formed of polyethylene, polypropylene, or a copolymer of polyethylene and polypropylene. The separator 214 may be wider than the positive and negative electrode plates 213 and 215 for reliably providing insulation between the positive and negative electrode plates 213 and 215.

The positive electrode tab 216 connected to the positive electrode plate 213, and the negative electrode tab 217 connected to the negative electrode plate 215 are extended from the electrode assembly 212. The insulating tapes 218 are wound around the positive electrode tab 216 and the negative electrode tab 217 at positions from which the positive electrode tab 216 and the negative electrode tab 217 extend from the electrode assembly 212, so as to provide insulation between the positive electrode plate 213 and the negative electrode plate 215.

The cap assembly 220, in one embodiment, includes a cap plate 221, a gasket 222, an electrode terminal 223, an insulating plate 224, a terminal plate 225, and an insulating case 226.

A terminal penetration hole 221 a is formed through a center part of the cap plate 221, in one embodiment, for receiving the electrode terminal 223, and the gasket 222 is disposed around the electrode terminal 223 for insulating the electrode terminal 223 from the cap plate 221. An electrolyte injection hole 221 b, in one embodiment, is formed in a side of the cap plate 221 for injecting electrolyte into the can 211. After the electrolyte is injected into the can 211, the electrolyte injection hole 221 b is closed using a stopple 227.

The electrode terminal 223, in one embodiment, is electrically connected to the negative electrode tab 217 and functions as a negative terminal. Alternatively, the electrode terminal 223 may be electrically connected to the positive electrode tab 216 and used as a positive terminal.

The insulating plate 224 is disposed at the bottom surface of the cap plate 221, and the terminal plate 225 is disposed at the bottom surface of the insulating plate 224. That is, the insulating plate 224 insulates the cap plate 221 from the terminal plate 225.

The terminal plate 225 is coupled to a lower end part of the electrode terminal 223. In one embodiment, the negative electrode plate 215 of the electrode assembly 212 is electrically connected to the terminal plate 225 and the electrode terminal 223 through the negative electrode tab 217. The positive electrode plate 213 of the electrode assembly 212 may be electrically connected to the bottom surface of the cap plate 221, such as by welding the positive electrode tab 216 to the bottom surface of the cap plate 221.

The insulating case 226 is disposed at the top surface of the electrode assembly 212. The insulating case 226 includes a negative electrode tab penetration part 226a, a positive electrode tab penetration part 226b, and an electrolyte injection hole 226c corresponding to the electrolyte injection hole 221 b for injecting the electrolyte into the can 211.

After the electrolyte is injected into the can 211 through the electrolyte injection holes 221 b and 226c, the electrolyte injection hole 221 b is closed using the stopple 227.

The protection circuit board 100 includes the board body 110 and the PTC device 120 disposed in the board body 110. In one embodiment, an electrode terminal 114 is provided at a lower end of the hole 111 formed in the center part of the board body 110, and lead plates 115 and 116 are disposed at both sides of the bottom surface of the board body 110. In one embodiment, the electrode terminal 114 is used as a negative terminal, and the lead plates 115 and 116 are used as positive terminals. Alternatively, the electrode terminal 114 may be used as a positive terminal, and the lead plates 115 and 116 may be used as negative terminals.

In the above-described secondary battery 200, the protection circuit board 100 is electrically connected to the bare cell 210.

In one embodiment, the electrode terminal 114 is spot-welded to the electrode terminal 223 of the bare cell 210 through the hole 111 of the board body 110. Also, in one embodiment, the lead plates 115 and 116 are connected to the top surface of the bare cell 210 by laser welding. In one embodiment, the electrode terminal 223 is a negative terminal of the bare cell 210, the cap plate 221 is a positive terminal of the bare cell 210, and at least one of the lead plates 115 and 116 is welded to the top surface of the cap plate 221 and is electrically connected to a positive terminal of the bare cell 210.

In the above-described secondary battery 200, the PTC device 120 (secondary protection device) is disposed inside the board body 110 so as to prevent fire or explosion of the secondary battery 200 by breaking a current when the temperature of the secondary battery 200 increases excessively due to either an internal or an external cause.

Because the PTC device 120 is disposed inside the board body 110, the PTC device 120 can be effectively insulated from the bare cell 210. Moreover, the PTC device 120 can be efficiently insulated from the bare cell 210 without requiring an additional component.

Furthermore, since the PTC device 120 is not located in a space between the protection circuit board 100 and the bare cell 210, other components or devices may be arranged in the space between the protection circuit board 100 and the bare cell 210.

A battery pack according to another exemplary embodiment of the present invention is described below.

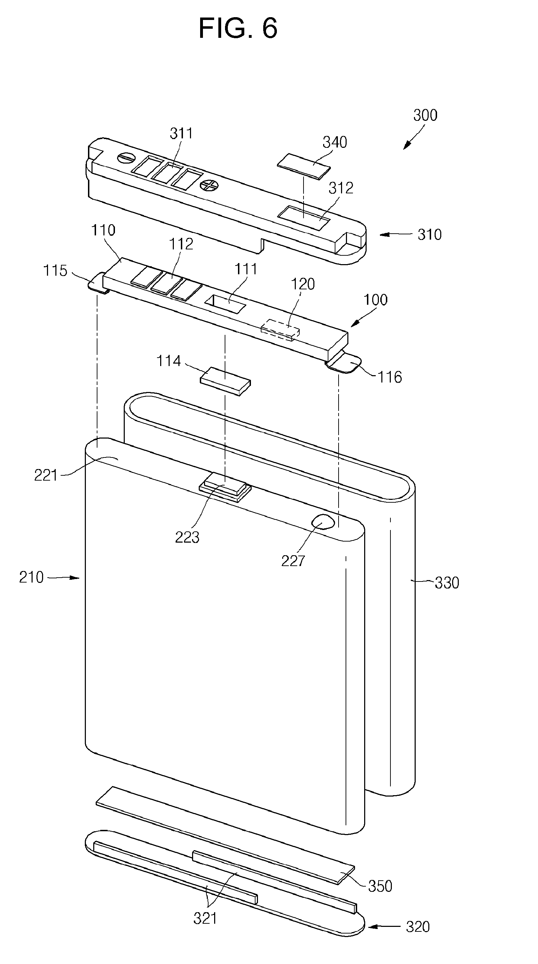

FIG. 6 is an exploded perspective view of a battery pack according to one exemplary embodiment of the present invention.

With reference to FIG. 6, in an exemplary embodiment, a battery pack 300 includes a bare cell 210, a protection circuit board 100 electrically connected to the bare cell 210, a top case 310 coupling the protection circuit board 100 to the top side of the bare cell 210, a bottom case 320 coupled to the bottom side of the bare cell 210, and a label sheet 330 wrapped around the sidewall of the bare cell 210 so as to couple the top case 310 and the bottom case 320 to the bare cell 210 and protect the sidewall of the bare cell 210.

The protection circuit board 100 includes a board body 110 in which a PTC device 120 is disposed. The protection circuit board 100 and the PTC device 120, in an exemplary embodiment, have the same or substantially similar structures as those of the protection circuit board 100 and the PTC device 120 described above. Therefore, in the following description, like reference numerals are used for the protection circuit board 100 and the PTC device 120, and detailed descriptions thereof are not repeated.

The top case 310 has a shape generally or approximately of a rectangular parallelepiped. An inner space of the top case 310 is sufficiently large for receiving the protection circuit board 100, and the bottom side of the top case 310 is open. In one embodiment, terminal holes 311 are formed in one side of the top case 310 so that external terminals 112 of the protection circuit board 100 can be exposed through the terminal holes 311, and a sheet attachment part 312 is formed at the other side of the top case 310 for attaching a submersion indication sheet 340 to the top case 310.

Lateral ribs 321 are formed on both longitudinal sides of the bottom case 320, in one embodiment, for supporting lower portions of longitudinal sides of the bare cell 210.

A double-sided tape 350 is disposed between the bare cell 210 and the bottom case 320 for bonding the bottom side of the bare cell 210 and the top side of the bottom case 320 together. In this way, the bottom case 320 is coupled to the bottom side of the bare cell 210.

The label sheet 330, in one embodiment, is wrapped around the lower end part of the top case 310, the lateral ribs 321 of the bottom case 320, and the sidewall of the bare cell 210.

In the battery pack 300, the bare cell 210 and the protection circuit board 100 are electrically connected to each other. That is, in an exemplary embodiment, the electrode terminal 223 (e.g., the negative terminal) of the bare cell 210 is electrically connected to the electrode terminal 114 of the protection circuit board 100. In addition, the cap plate 221 (e.g., the positive terminal) of the bare cell 210 is electrically connected to the lead plates 115 and 116 of the protection circuit board 100.

In the battery pack 300, heat can be transferred to the PTC device 120 disposed in the protection circuit board 100 through the electrode terminal 223. Therefore, if the temperature of the battery pack 300 increases excessively, the PTC device 120 can break a current to prevent fire or explosion of the battery pack 300.

The PTC device 120 is installed inside the board body 110, and the top and bottom surfaces of the board body 110, in one embodiment, are coated with PSR to form an insulating layer. As such, more reliable insulation can be provided between the protection circuit board 100 and the bare cell 210. Further, an additional component is not needed for insulating the PTC device 120 from the bare cell 210.

In addition, a space between the protection circuit board 100 and the bare cell 210 can be saved. Therefore, another component or device can be placed in the saved space, or the size of the battery pack 300 can be reduced.

As described above, according to one exemplary embodiment of the present invention, a protection circuit board has a simple structure having a secondary protection device disposed therein. The secondary protection device can be simply installed at the protection circuit board.

According to another exemplary embodiment of the present invention, a secondary battery includes a protection circuit board having a secondary protection device disposed therein for effectively insulating the secondary protection device from a bare cell. As such, a process for insulating the secondary protection device from the bare cell may be unnecessary.

According to another exemplary embodiment of the present invention, a battery pack includes a secondary protection device disposed inside a protection circuit board for saving a space between the protection circuit board and a bare cell. As such, the size of the battery pack may be reduced.

Certain exemplary embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the spirit and scope of the present invention as set forth in the following claims.

## Claims

1. A protection circuit board (100) comprising:
a board body (110); and
a secondary protection device (120) inside the board body.

2. The protection circuit board as claimed in claim 1, wherein the board body has a generally rectangular parallelepiped shape and a hole (111) at a central portion,
wherein the protection circuit board further comprises an external terminal (112) at one surface of the board body, and a charge/discharge device (113) on another surface of the board body.

3. The protection circuit board as claimed in claim 1 or 2, wherein the board body comprises at least two circuit layers (114a - 114d),
wherein a first end part (122) of the secondary protection device is connected to an uppermost layer (114a) of the circuit layers, and a second end part (123) of the secondary protection device is connected to a lowermost layer (114d) of the circuit layers.

4. The protection circuit board as claimed in anyone of claims 1 to 3, further comprising insulating layers on top and bottom surfaces of the board body.

5. The protection circuit board as claimed in claim 4, wherein the insulating layers comprise photoimageable solder resist (PSR) layers.

6. The protection circuit board as claimed in anyone of claims 1 to 5, wherein the secondary protection device is not exposed outside the board body.

7. The protection circuit board as claimed in anyone of claims 1 to 6, wherein the secondary protection device comprises a positive temperature coefficient (PTC) device.

8. The protection circuit board as claimed in claim 7, wherein the PTC device comprises:
a PTC main body (121) having a generally rectangular parallelepiped shape;
a first conductive part (122) on at least one surface of the PTC main body; and
a second conductive part (123) spaced apart from the first conductive part and on at least one surface of the PTC main body that does not have the first conductive part thereon.

9. A secondary battery (200) comprising:
a bare cell (210); and
a protection circuit board (100) as defined in anyone of claims 1 to 8 and electrically connected to the bare cell.

10. The secondary battery as claimed in claim 9, wherein the bare cell comprises:
a can (211);
an electrode assembly (212) in the can; and
a cap assembly (220) for closing an opening of the can.

11. The secondary battery as claimed in claim 9 or 10, wherein the protection circuit board further comprises:
an electrode terminal (114) at a center part of the board body and connected to a first electrode of the bare cell; and
electrodes (115, 116) at end parts of the board body and connected to a second electrode of the bare cell.

12. A battery pack (300) comprising:
a secondary battery as defined in anyone of claims 9 to 11 ; and
a top case (310) coupling the protection circuit board (100) to a side of the bare cell (210).

13. The battery pack as claimed in claim 12, further comprising a bottom case (320) coupled to another side of the bare cell (210).

14. The battery pack as claimed in claim 12 or 13, further comprising a label sheet (330) enclosing lateral surfaces of the bare cell (210), the top case (310), and the bottom case (320).
